# EUROPEAN PATENT SPECIFICATION

(11) **EP 0 381 372 B1**
(45) Date of publication and mention of the grant of the patent: **10.04.1996**
(21) Application number: 90300770.6
(22) Date of filing: 25.01.1990
(51) Int. Cl.: H05K 3/26, C23G 5/04, B08B 3/08

(54) **Technique for cleaning a circuit board with a combustible cleaning solvent**
Verfahren zur Reinigung einer Leiterplatte mit einem brennbaren Reinigungslösungsmittel
Technique de nettoyage d'une plaquette de circuits imprimés avec un solvant de nettoyage combustible

(30) Priority: 01.02.1989 US 304533
(43) Date of publication of application: 08.08.1990
(73) Proprietor: AT&T Corp., New York, NY 10013-2412 (US)
(72) Inventor: Dickinson, David Alan, Titusville, New Jersey 08560 (US); Munie, Gregory C., Illinois, 60565 (US); Wenger, George Michael, New Jersey 08873 (US)
(74) Representative: Johnston, Kenneth Graham

(56) References cited:
- EP-A- 0 286 880
- EP-A- 0 387 001
- WO-A-87/00209
- DE-C- 3 328 091
- US-A- 3 868 272
- US-A- 4 474 199

## Description

This invention relates to methods and apparatus for cleaning a circuit board with a terpene-based solvent.

Prior to soldering of the leads or pads of an electronic component to corresponding metallized areas on a circuit board, soldering flux is commonly applied to the metallized areas to clean them and promote wetting by the solder. By cleaning the metallized areas on the board, the solder bond between the component and the circuit board is greatly enhanced. Presently, most electronics manufacturers employ rosin-based fluxes because they are much less chemically active as compared to water-soluble fluxes, which tend to be much more active, and much more corrosive.

The disadvantage of most rosin-based fluxes is that after soldering, such fluxes often leave an insulative residue on the metallized areas on the circuit board. The flux residue makes it difficult to establish an electrical contact between each of a plurality of selected metallized areas on the circuit board and each of a set of probes brought into contact therewith to couple each metallized area to a testing machine which tests the circuit board. Unless a reliable contact is obtained between each probe and each selected metallized area, the testing machine cannot accurately test the circuit board.

Circuit boards fluxed with rosin-based fluxes are commonly sprayed or brushed with a cleaning solvent, typically a detergent or chlorofluorocarbon, to remove the undesirable flux residues after soldering to ensure accurate testing. However, neither detergents or chlorofluorocarbons are completely satisfactory as cleaning solvents. Spent detergents usually require treatment before discharge into a municipal sewer system, which significantly increases the cost of cleaning with detergents. Chlorofluorocarbons have been found detrimental to the environment and they are likely to be banned from use within the next several years.

For these reasons, much effort has been devoted towards finding a cleaning solvent which overcomes the shortcomings of detergents and chlorofluorocarbons. We found that a terpene-based solvent, known commercially as BIOACT® EC-7 chemical made by Petroferm Inc., Ameila, Florida, when brushed onto a circuit board, successfully removed flux residues about component leads inserted through apertures in the board. However, the terpene-based cleaning solvent, when brushed on the circuit board, did not adequately remove flux residues underneath components mounted on the surface(s) of the board.

WO-A-8-87/00209 is directed to a method of cleaning residues, such as rosin-based soldering flux or adhesive tape residues, from a printed circuit board by the use of a terpene-based cleaner. Such a terpene-based cleaner has been found to dissolve adhesive tape and rosin-based solder flux residues. The terpene-based cleaner may be applied in a variety of ways, such as brushing or spraying. However, spraying of such terpene-based cleaners has been found to give rise to a mist which can be potentially explosive.

US-A-4 474 199 discloses an apparatus and a method for cleaning or stripping coated objects by immersion in a bath of solvent. This is applied under an inert atmosphere to avoid any risk of fire or explosion and to separate solvent from coating material.

EP-A 0 286 880 is directed to a technique for de-watering mechanical parts by immersing the parts in an air-tight tank filled with a liquid having a density less than water. A volume of inert gas is admitted into the tank above the liquid. When a mechanical part, such as a nut or screw, is immersed in the liquid, any water carried by the part will fall to the bottom of the tank so as to be drained off through a drain.

Thus, there is a need for a technique for cleaning an object, such as a circuit board, with a terpene-based cleaner to remove flux residues, including those underneath components mounted on the surface of the board.

According to one aspect of this invention there is provided a method as claimed in claim 1.

According to another aspect of this invention there is provided apparatus as claimed in claim 9.

Briefly, residues, and particularly flux residues, can be substantially removed from a circuit board, by spraying the board with a combustible, terpene-based cleaning solvent, However, when the combustible, terpene-based cleaning solvent was sprayed on the circuit board, we found that a potentially explosive mist was formed, generated in part by the solvent bouncing back from the surface of the circuit board. The risk incurred by spraying the circuit board with the terpene-based cleaning solvent is substantially reduced by carrying out such spraying or otherwise depositing, then agitating, the solvent on the board in a environment substantially devoid of oxygen. In a first embodiment, the spray cleaning is carried out in an enclosure continuously flooded with an inert gas, such as nitrogen, so that the oxygen concentration in the enclosure remains below a predetermined level. In a second embodiment, the cleaning is performed within a tank containing the terpene-based cleaning solvent. The solvent is sprayed or agitated against the circuit board inside the tank under or below the level of the cleaning solvent where substantially no oxygen is present. Under these conditions, the "bounce back" of the solvent from the surface of the circuit board is eliminated.

### Brief Description of the Drawing

FIG. 1 is a cutaway side view of a spray cleaning machine embodying the invention; and
FIG. 2 is a cutaway side view of another spray cleaning machine embodying the invention.

### Detailed Description

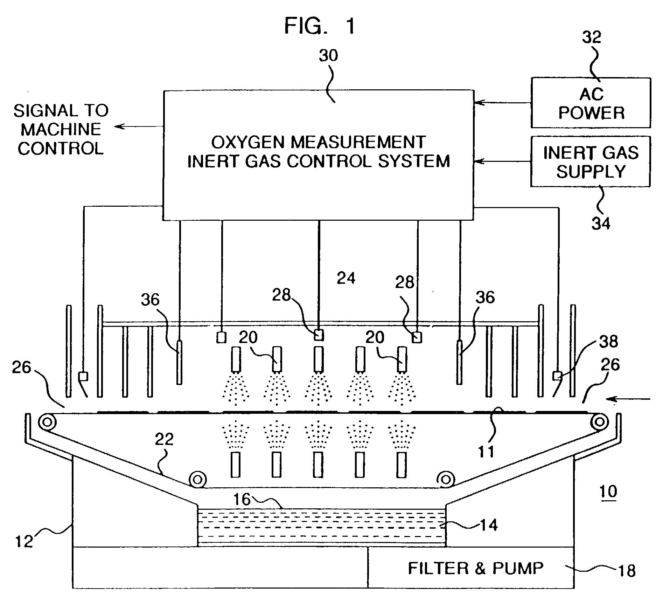

FIG. 1 is cutaway side view of a first embodiment 10 of a cleaning machine embodying the invention for cleaning flux residues on a circuit board 11 fluxed with rosin flux. The machine 10 comprises a frame 12 whose top is open. Within the frame 12 is a tank 14 containing a volume of cleaning solvent 16 capable of removing the flux residues on the circuit board 11. In the preferred embodiment, we chose the cleaning solvent 16 to be a terpene-based material commercially known as BIOACT® EC-7 chemical made by Petroferm Inc, Amelia, Florida. We found that BIOACT® EC-7 chemical, when sprayed on the circuit board 11, removed the flux residues, including residues underneath components (not shown) mounted on the surface(s) of the board, as well or better than conventional detergents and chlorofluorocarbons but without the disadvantages associated with each.

To spray the cleaning solvent 16 onto the circuit board 11, a pump and filter system 18 is mounted within the frame 12 for pumping the cleaning solvent from the tank 14 into each of a plurality of nozzles 20 which could alternatively be configured of orifices or jets. The nozzles 20 are arranged above the tank 14 to spray the solvent against the top and bottom of that portion of an open-mesh conveyor 22 which passes through the machine 10 above the tank. The conveyor 22 serves to carry individual circuit boards 11 across the tank 14 so that the top and bottom surfaces of the board are sprayed by the nozzles 20 with the cleaning solvent 16 which removes the flux residues on each surface of the board. Since the spraying occurs above the tank 14, most of the cleaning solvent 16 sprayed onto each circuit board 11 falls back into the tank.

An enclosure 24 encloses the top of the frame 12 to contain any vapors generated when the solvent 16 is sprayed against each circuit board 11. A pair of openings 26 is necessarily provided through the enclosure 24 at opposite ends thereof to allow the conveyor 22 to pass therethrough so that a dirty circuit board 11 (i.e., one having flux residues thereon) may be admitted into the enclosure and a clean board may be removed.

While the cleaning solvent 16 was sprayed against the top and bottom surface of each circuit board 11, we found that a mist was generated, created in part by "bouncing back" from the surface of the board. The mist created by spraying the solvent 16 was found to be potentially explosive when ignited. Although the BIOACT® EC-7 chemical was known to be combustible, heretofore, it was not known to be potentially explosive under these conditions. Thus, the potential risk of explosion incurred by spraying each circuit board 11 with the cleaning solvent 16 was unexpected.

Advantageously, we found that this potential risk of explosion could be significantly reduced, if not altogether avoided, by spraying the circuit boards 11 with the cleaning solvent 16 in an environment substantially devoid of oxygen. To carry out the spraying of the cleaning solvent 16 in a substantially oxygen-free environment, a plurality of oxygen sensors 28 is provided inside of the enclosure 24 for sensing the concentration of oxygen. The oxygen sensors 28 are each coupled to an oxygen measurement and inert gas control system 30 which is powered with alternating current from a power source 32. In the preferred embodiment, the control system 30 comprises the combination of a model 3-SS-V oxygen measurement system and a model 6000 inert gas controller manufactured by Neutronics Inc, Exton, Pennsylvania.

The control system 30 regulates the flow of an inert gas, typically nitrogen, from an inert gas supply 34, into a set of discharge jets 36 inside the enclosure 24 in accordance with the oxygen concentration sensed by the sensors 28. In practice, the flow of nitrogen into the discharge jets 36 is regulated so that the concentration of oxygen inside the enclosure 24 does not exceed a minimum oxygen concentration (MOC). For the BIOACT® EC-7 solvent, the MOC has been estimated at 9.7%. For other types of solvents, the MOC will likely be different. Should the control system 30 be unable to maintain the concentration of oxygen at or below the minimum oxygen concentration, as will occur when the gas supply 34 is empty, the control system sends a signal to the controller (not shown) for the machine 10 to halt the operation thereof.

For so long as the concentration of oxygen inside the enclosure 24 is maintained at or below the MOC, ignition of the mist, generated in part by the cleaning solvent 16 bouncing back from the circuit board 11 during spraying becomes virtually impossible. By virtually eliminating ignition of the cleaning solvent mist, the risk of explosion is eliminated.

As may be appreciated, we eliminate the risk of explosion by flooding the void or chamber inside of the enclosure 24 with nitrogen to dilute the concentration of oxygen. However, since the enclosure 24 is provided with the openings 26 at each of its ends, nitrogen must be continuously admitted into the enclosure to replace that which escapes through these openings. To reduce the volume of nitrogen which escapes, a knife discharge jet 38 is situated adjacent each opening 26 and is continuously supplied with nitrogen from the control system 30 to provide a gas knife which effectively seals the opening. Instead of providing an inert gas knife adjacent to each of the openings 26 in the enclosure 24, a fluid seal could alternatively be employed to reduce the escape of the inert gas. The use of an inert gas knife is advantageous because the gas striking the circuit boards 11 leaving the enclosure 24 serves to drive off the solvent 16 remaining on the board after cleaning. In some instances, it may be desirable to additionally provide an air knife (not shown) for this purpose.

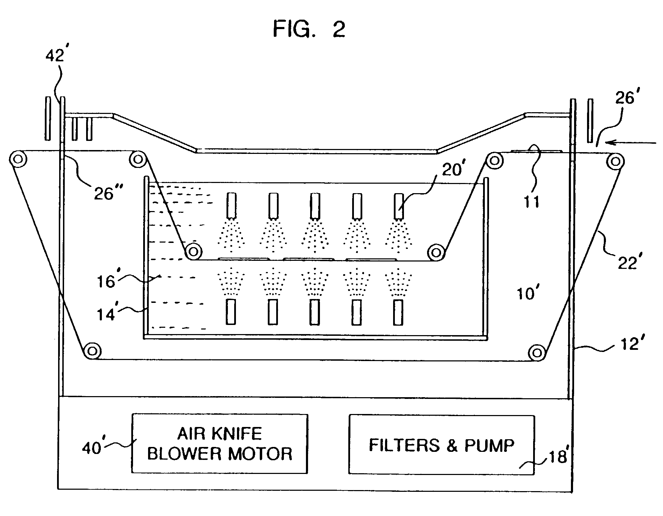

Referring to FIG. 2, there is shown an alternate preferred embodiment 10′ of a machine for spray cleaning a circuit board 11. The machine 10′ is comprised of a frame 12′ which, unlike the frame 12 of the machine 10 of FIG. 1, is substantially closed. Inside the frame 12′ of FIG. 2 is a tank 14′ much larger than the tank 14 of FIG. 1. The tank 14′ of FIG. 2 contains a volume of cleaning solvent 16′ which, in the preferred embodiment, takes the form of BIOACT® EC-7 chemical, the same terpene-based material as the solvent 16 of FIG. 1.

The solvent 16′ of FIG. 2 is pumped by a pump and filter system 18′ into each of a plurality of nozzles 20′ (or alternately, jets or orifices) situated within the tank 14′. The nozzles 20′ (or alternatively, jets or orifices) are arranged so that about half are directed at the top, and the other half are directed at the bottom, of a portion of an open-mesh conveyor passing through the tank 14′. The conveyor 22 operates to carry individual circuit boards 11 through a first opening 26′ in the frame 12′ and into the tank 14′ where the nozzles 20′ spray the solvent 16′ at the top and bottom surfaces of the circuit boards. After spraying, the circuit boards 11 are carried by the conveyor 22′ out through an opening 26˝ in the frame 12′ opposite the opening 26. As each circuit board 11 is carried out through the opening 26˝, air is forced by a blower 40′ through jet 42′ adjacent to the opening to create an air knife which serves to blow off excessive cleaning solvent 16′ from the board.

During the operation of the machine 10′ of FIG. 2, the level of the cleaning solvent 16′ in the tank 14′ is maintained above that of the highest elevation nozzles 20′ Hence, the spraying of the cleaning solvent 16′ against the upper and lower surfaces of the circuit board 11 occurs below, that is, underneath, the level of the cleaning solvent in the tank 14′. The reason for carrying out the spraying at a level below that of the cleaning solvent 16′ in the tank 14′ is that underneath the level of the solvent, insufficient oxygen exists to support its ignition. Accordingly, the risk of explosion arising from spraying the circuit board 11 with the cleaning solvent 16' is virtually eliminated.

The effect of spraying the cleaning solvent 16' through the nozzles 20' at each circuit board 11 immersed within the tank 14' is to agitate the solvent surrounding each board. We have found that agitating the cleaning solvent 16' surrounding each circuit board 11 in this manner caused substantially all the flux residues, including those underneath components mounted on the surface(s) of the board, to be removed. Rather than employ the particular arrangement of nozzles 20' shown in FIG. 2, other nozzle arrangements could be employed to agitate the volume of solvent 16' surrounding the circuit boards 11 in the tank 14'. For example, instead of directing the nozzles 20' at the top and bottom of the conveyor 22', the nozzles could be arranged either at an angle, or parallel to the conveyor and on opposite sides thereof, to spray the solvent 16' at opposite sides of the boards on the conveyor. By causing the solvent to strike the board at an angle, or parallel to the board, the flow of solvent towards the undersurface of the components on the board is maximized. Alternatively, means other than the nozzles 20', such as a rotating turbine blade (not shown), could be employed to agitate the volume of the solvent 16' surrounding the circuit boards 11 so the solvent will remove any flux residues on the board.

As compared to the machine 10 of FIG. 1, the machine 10' of FIG. 2 is less expensive to construct. Unlike the machine 10 of FIG. 1, the machine 10' of FIG. 2 requires no mechanism for inert gas injection to maintain the circuit boards in a substantially oxygen-free environment. Accordingly, the machine 10' of FIG. 2 is also less expensive to operate because no inert gas is required for operation.

The foregoing describes a technique for cleaning an object, such as a circuit board 11, with a terpene-based cleaning solvent 16' in environment substantially free of oxygen to reduce the potential risk of explosion.

It is to be understood that the above-described embodiments are merely illustrative of the invention. While the spray cleaning technique is especially useful for removing solder flux residues, other type of oily or soil residues may be removed using this technique.

## Claims

1. A method for cleaning a circuit board (11) with a terpene-based cleaning solvent to remove residues from the circuit board, comprising the step of spraying the cleaning solvent (16,16') at the circuit board (11), and CHARACTERIZED BY the step of simultaneously maintaining the circuit board in an environment (14',24) substantially devoid of oxygen while spraying the solvent to reduce the risk that mist, formed by spraying the cleaning solvent, will ignite and potentially explode.

2. A method according to claim 1 wherein the circuit board (11) is maintained in the environment (14',24) substantially devoid of oxygen by flooding the environment surrounding the circuit board with an inert gas.

3. A method according to claim 2 wherein the environment (14',24) surrounding the circuit board (11) is flooded with inert gas such that the concentration of oxygen about the circuit board is maintained at a level no greater than a predetermined oxygen concentration level.

4. A method according to claim 2 wherein the inert gas which floods the environment surrounding the circuit board (11) is nitrogen.

5. A method according to claim 1 wherein the circuit board (11) is maintained in the surrounding environment (14') devoid of oxygen by immersing the circuit board within the cleaning solvent (16') while the circuit board is being sprayed with the solvent.

6. A method according to claim 1 wherein the circuit board (11) is transported in the environment (14'24) by a conveyor, and the circuit board is sprayed in the environment with the cleaning solvent (16).

7. A method according to claim 1 wherein the circuit board (11) is transported into a tank (14') containing the cleaning solvent (16') so that the circuit board is immersed within the solvent, and the solvent surrounding the immersed circuit board is agitated.

8. A method of fabricating a circuit board comprising the steps of applying soldering flux to the circuit board (11), soldering at least one component to the circuit board, and cleaning the circuit board after soldering by a method as claimed in any one of claims 1-7.

9. Apparatus (10.10') for spray cleaning a circuit board (11) with a terpene-based cleaning solvent, comprising means (14,16,18,20) for spraying the circuit board with a terpene-based cleaning solvent, and CHARACTERIZED BY means (24,26,28,30,32,34) for maintaining the circuit board in an environment which is substantially devoid of oxygen while the circuit board is sprayed with the terpene-based cleaning solvent.

10. Apparatus according to claim 9 wherein the means for maintaining the circuit board in the environment devoid of oxygen comprises an enclosure (24) having an entrance and exit at opposite ends thereof, means (28) for sensing the concentration of oxygen in the enclosure, means (34,36) for admitting inert gas into the enclosure, and control means (30) responsive to the sensing means for controlling the inert gas admitted by the admitting means so that the concentration of oxygen in the enclosure does not exceed a predetermined level.

11. Apparatus according to claim 10 comprising a conveyor (22) for transporting the circuit board through the enclosure.

## Patentansprüche

1. Verfahren zur Reinigung einer Leiterplatte (11) mit einem terpenhaltigen Lösungsmittel für Rückstände auf der Leiterplatte, bei dem man die Leiterplatte (11) mit dem Lösungsmittel (16, 16') besprüht, dadurch gekennzeichnet, daß man zur Verringerung der Gefahr der Entzündung und möglichen Explosion des Sprühnebels die Leiterplatte in einer weitgehend sauerstofffreien Umgebung (14', 24) besprüht.

2. Verfahren nach Anspruch 1, bei dem man die Umgebung (14', 24) der Leiterplatte (11) mit einem Inertgas weitgehend sauerstofffrei beflutet.

3. Verfahren nach Anspruch 2, bei dem man die Umgebung (14', 24) der Leiterplatte (11) mit einem Inertgas so beflutet, daß die Sauerstoffkonzentration in der Nähe der Leiterplatte einen vorbestimmten Sauerstoffkonzentrationswert nicht überschreitet.

4. Verfahren nach Anspruch 2, bei dem man als Inertgas zum Befluten der Umgebung der Leiterplatte (11) Stickstoff einsetzt.

5. Verfahren nach Anspruch 1, bei dem man die Leiterplatte (11) beim Besprühen dadurch in einer sauerstofffreien Umgebung (14') hält, daß man sie im Lösungsmittel (16') eintaucht.

6. Verfahren nach Anspruch 1, bei dem man die Leiterplatte (11) mittels einer Fördervorrichtung in der Umgebung (14', 24) transportiert und dabei mit dem Lösungsmittel (16) besprüht.

7. Verfahren nach Anspruch 1, bei dem man die Leiterplatte (11) in einen das Lösungsmittel (16') enthaltenden Tank (14') transportiert, so daß die Leiterplatte in das Lösungsmittel eingetaucht ist, und das die eingetauchte Leiterplatte umgebende Lösungsmittel bewegt.

8. Verfahren zur Herstellung einer Leiterplatte, bei dem man ein Lötflußmittel auf die Leiterplatte (11) aufbringt, mindestens eine Komponente auf die Leiterplatte auflötet und nach dem Auflöten die Leiterplatte nach einem Verfahren gemäß einem der Ansprüche 1-7 reinigt.

9. Vorrichtung (10, 10') zur Sprühreinigung einer Leiterplatte (11) mit einem terpenhaltigen Lösungsmittel mit Einrichtungen (14, 16, 18, 20) zum Besprühen der Leiterplatte mit einem terpenhaltigen Lösungsmittel, gekennzeichnet durch Einrichtungen (24, 26, 28, 30, 32, 34), die die Leiterplatte während des Besprühens mit dem terpenhaltigen Lösungsmittel in einer weitgehend sauerstofffreien Umgebung halten.

10. Vorrichtung nach Anspruch 9, bei der die Einrichtung zum Halten der Leiterplatte in einer sauerstofffreien Umgebung ein Gehäuse (24) mit einem Eingang und einem Ausgang an entgegengesetzten Enden, Einrichtungen (28) zur Messung der Sauerstoffkonzentration im Gehäuse, Einrichtungen (34, 36) zum Einleiten von Inertgas in das Gehäuse und eine Steuereinrichtung (30), die auf die Meßeinrichtung zur Überwachung der von den Einleitungseinrichtungen eingeleiteten Inertgases so anspricht, daß die Sauerstoffkonzentration in dem Gehäuse einen vorbestimmten Wert nicht überschreitet, aufweist.

11. Vorrichtung nach Anspruch 10, die eine Fördereinrichtung (22) zum Transportieren der Leiterplatte durch das Gehäuse aufweist.

## Revendications

1. Méthode de nettoyage d'une plaquette de circuit imprimé (11) à l'aide d'un solvant de nettoyage à base de terpène pour enlever des résidus de la plaquette de circuit imprimé, comprenant l'étape consistant à pulvériser le solvant de nettoyage (16,16') sur la plaquette de circuit imprimé (11), et CARACTERISEE par l'étape du maintien simultané de la plaquette de circuit imprimé dans un environnement (14', 24) substantiellement dépourvu d'oxygène tout en pulvérisant le solvant pour réduire le risque d'inflammation et potentiellement d'explosion du brouillard formé par la pulvérisation du solvant de nettoyage.

2. Méthode selon la revendication 1, dans laquelle la plaquette de circuit imprimé (11) est maintenue dans l'environnement (14', 24) substantiellement dépourvu d'oxygène par un noyage de l'environnement entourant la plaquette de circuit imprimé avec un gaz inerte.

3. Méthode selon la revendication 2, dans laquelle l'environnement (14', 24) entourant la plaquette de circuit imprimé (11) est noyé avec un gaz inerte de telle sorte que la concentration en oxygène autour de la plaquette de circuit imprimé est maintenue à un niveau non supérieur à un niveau de concentration en oxygène prédéterminé.

4. Méthode selon la revendication 2, dans laquelle le gaz inerte qui noie l'environnement entourant la plaquette de circuit imprimé (11) est de l'azote.

5. Méthode selon la revendication 1, dans laquelle la plaquette de circuit imprimé (11) est maintenue dans l'environnement (14') dépourvu d'oxygène qui l'entoure par immersion de la plaquette de circuit imprimé dans le solvant de nettoyage (16') durant la pulvérisation de la plaquette de circuit imprimé avec le solvant.

6. Méthode selon la revendication 1, dans laquelle la plaquette de circuit imprimé (11) est transportée dans l'environnement (14', 24) par un transporteur, et la plaquette de circuit imprimé est pulvérisée dans l'environnement avec le solvant de nettoyage (16).

7. Méthode selon la revendication 1, dans laquelle la plaquette de circuit imprimé (11) est transportée dans un réservoir (14') contenant le solvant de nettoyage (16') de telle sorte que la plaquette de circuit imprimé est immergée dans le solvant, et que le solvant entourant la plaquette de circuit imprimé immergée est agité.

8. Méthode de fabrication d'une plaquette de circuit imprimé comprenant les étapes d'application du flux de soudure à la plaquette de circuit imprimé (11), de soudage d'au moins un composant à la plaquette de circuit imprimé, et de nettoyage de la plaquette de circuit imprimé après le soudage par une méthode selon l'une quelconque des revendications 1 à 7.

9. Appareil (10, 10') pour nettoyer par pulvérisation une plaquette de circuit imprimé (11) à l'aide d'un solvant de nettoyage à base de terpène, comprenant des moyens (14, 16, 18, 20) pour pulvériser la plaquette de circuit imprimé avec un solvant de nettoyage à base de terpène, et CARACTERISE par des moyens (24, 26, 28, 30, 32, 34) pour maintenir la plaquette de circuit imprimé dans un environnement qui est substantiellement dépourvu d'oxygène pendant que la plaquette de circuit imprimé est pulvérisée avec le solvant de nettoyage à base de terpène.

10. Appareil selon la revendication 9, dans lequel les moyens pour maintenir la plaquette de circuit imprimé dans l'environnement dépourvu d'oxygène comprennent une enceinte (24) avec une entrée et une sortie à ses extrémités opposées, un moyen (28) pour détecter la concentration en oxygène dans l'enceinte, un moyen (34, 36) pour admettre du gaz inerte dans l'enceinte, et un moyen de contrôle (30) répondant au moyen de détection pour contrôler le gaz inerte admis par le moyen d'admission de façon à ce que la concentration en oxygène dans l'enceinte n'excède pas un niveau prédéterminé.

11. Appareil selon la revendication 10, comprenant un transporteur (22) pour transporter la plaquette de circuit imprimé à travers l'enceinte.
